# EUROPÄISCHE PATENTSCHRIFT

(11) **EP 3 738 044 B1**
(45) Veröffentlichungstag und Bekanntmachung des Hinweises auf die Patenterteilung: **13.03.2024**
(21) Anmeldenummer: 18840053.5
(22) Anmeldetag: 17.12.2018
(51) Int. Cl.: G06F 13/42, G11C 5/14, G06F 1/28, G06F 11/22, G06F 13/12, G11C 29/02

(54) **SPANNUNGSDIAGNOSESCHALTUNG**
VOLTAGE DIAGNOSTIC CIRCUIT
CIRCUIT DE DIAGNOSTIC DE TENSION

(30) Priorität: 08.01.2018 DE 102018000063
(43) Veröffentlichungstag der Anmeldung: 18.11.2020
(73) Patentinhaber: WAGO Verwaltungsgesellschaft mit beschränkter Haftung, 32423 Minden (DE)
(72) Erfinder: WOHLGEMUTH, Christopher, 32427 Minden (DE); VOSS, Christian, 32427 Minden (DE)
(74) Vertreter: Koplin, Moritz
(86) Internationale Anmeldenummer: PCT/IB2018/060187
(87) Internationale Veröffentlichungsnummer: WO 2019/135132

(56) Entgegenhaltungen:
- EP-A1- 2 738 990
- DE-A1-102016 201 141
- US-A1- 2017 184 642

## Beschreibung

### GEBIET

Die vorliegende Erfindung bezieht sich auf eine Schaltung zur Überwachung einer Spannungsversorgung.

### HINTERGRUND

Aus der DE 10 2016 201141 A1 ist eine Sicherheitsanaordnung bekannt, welche eine Datenverarbeitungseinheit zur seriellen Übertragung von Daten zur Ansteuerung von Ausgängen und zur Abfrage von Eingängen aufweist und weiterhin mindestens einen Parallel-Seriell-Wandler mit einem Schieberegister zur Umwandlung von Daten zur Abfrage der Eingänge, und mindestens einen Seriell-Parallel-Wandler mit einem Schieberegister zur Umwandlung von Daten zur Ansteuerung der Ausgänge, wobei die zu übertragenden Daten Diagnosebits enthalten, die vom Seriell-Parallel-Wandler ausgegeben und vom Parallel-Seriell-Wandler zurückgelesen werden.

Aus der US 2017/184642 A1 ist ein Mikrocontroller bekannt, der eingerichtet ist, alternierend zwei Energieversorgungslevel zu überwachen, wenn der Mikrocontroller in einem Batteriegestützten Backup-Modus läuft.

Zur Überwachung einer Spannungsversorgung sind aus dem Stand der Technik Mikrocontroller bekannt, die einen separaten Diagnoseeingangs-Pin zur Verbindung mit einer Diagnoseschaltung aufweisen, wobei die Mikrocontroller eingerichtet sind, ein von der Diagnoseschaltung bereitgestelltes Statussignal hinsichtlich der Spannungsversorgung über den separaten Diagnoseeingangs-Pin einzulesen und auszuwerten.

### ZUSAMMENFASSUNG

Die Erfindung bereichert diesbezüglich den Stand der Technik, als ein Mikrocontroller einer erfindungsgemäßen Schaltung zum Einlesen eines von einer Diagnoseschaltung bereitgestellten Statussignals keinen separaten Diagnoseeingangs-Pin benötigt. Stattdessen wird das Statussignal erfindungsgemäß über einen seriellen Eingang des Mikrocontrollers eingelesen, wobei der serielle Eingang mit einem seriellen Ausgang eines Schieberegisters verbunden ist. Das Schieberegister weist zumindest einen Dateneingang auf, welcher mit einem Diagnoseausgang einer Diagnoseschaltung zur Eingabe des Statussignals verbunden ist.

Dabei ist unter dem Begriff "serieller Eingang", wie er in der Beschreibung und den Ansprüchen verwendet wird, insbesondere ein Anschluss (bzw. Eingangs-Pin) zu verstehen, über den in einem bestimmten Zeittakt Daten nacheinander eingelesen werden können. Analog dazu ist unter dem Begriff "serieller Ausgang", wie er in der Beschreibung und den Ansprüchen verwendet wird, insbesondere ein Anschluss (bzw. Ausgangs-Pin) zu verstehen, über den in einem bestimmten Zeittakt Daten nacheinander ausgelesen werden können.

Ferner ist unter dem Begriff "Schieberegister", wie er in der Beschreibung und den Ansprüchen verwendet wird, insbesondere eine Schaltung mit mehreren in Reihe geschalteten Speichereinheiten (bspw. Flipflops) zu verstehen, deren Speicherinhalt (bspw. je 1 Bit) bei jedem Arbeitstakt um eine Speichereinheit weitergeschoben wird. Des Weiteren ist unter dem Begriff "Diagnoseschaltung", wie er in der Beschreibung und den Ansprüchen verwendet wird, insbesondere eine Schaltung zu verstehen, die eine Korrektheit des Funktionierens einer Schaltung bzw. deren Voraussetzungen überprüft und erkannte tatsächliche oder mögliche Beeinträchtigungen signalisiert.

Vorzugsweise ist der Dateneingang Bestandteil einer parallelen Schnittstelle des Schieberegisters.

Dabei ist unter dem Begriff "parallele Schnittstelle", wie er in der Beschreibung und den Ansprüchen verwendet wird, insbesondere eine Schnittstelle zu verstehen, über die mehrere (insbesondere voneinander unabhängige) Signale parallel (und somit insbesondere zeitgleich) abgetastet werden können.

Vorzugsweise ist der Dateneingang des Schieberegisters zur Speicherung des Diagnosebits an einem Speicherplatz eingerichtet, dessen Inhalt bei der seriellen Ausgabe zuerst ausgegeben wird.

Dabei ist unter dem Begriff "Diagnosebit", wie er in der Beschreibung und den Ansprüchen verwendet wird, insbesondere ein Signal zu verstehen, welches einen von zwei unterschiedlichen Werten repräsentiert, wobei die Werte den Zustand der Spannungsversorgung charakterisieren, bspw. Spannungsversorgung "fehlerfrei"" und Spannungsversorgung "fehlerhaft". Ferner ist unter der Formulierung "zuerst ausgeben", wie er in der Beschreibung und den Ansprüchen verwendet wird, insbesondere ein Ausgeben zu verstehen, welches zeitlich vor dem Ausgeben weiterer Bits, die ebenfalls in dem Schieberegister gespeichert sind, erfolgt.

Vorzugsweise ist das Schieberegister zum Anlegen eines dem Diagnosebit entsprechenden Wertes an den Eingang des Mikrocontrollers ohne Anliegen eines Taktsignals an einem Takteingang des Schieberegisters und/oder einer an dem Schieberegister anliegenden Logikspannung eingerichtet.

Dabei ist unter der Formulierung "ohne Anliegen eines Taktsignals", wie er in der Beschreibung und den Ansprüchen verwendet wird, insbesondere zu verstehen, dass zwischen dem Anlegen eines dem Diagnosebit entsprechenden Wertes an den Eingang des Mikrocontrollers und dem Anliegen eines Taktsignals kein positiv kausaler Zusammenhang besteht.

Vorzugsweise umfasst die Schaltung ferner einen oder mehrere Sensoren, die zum Anschluss an eine zweite Spannungsversorgung ausgebildet sind, wobei ein oder mehrere Dateneingänge des Schieberegisters mit dem einen oder den mehreren Sensoren zur Eingabe von Sensordaten verbunden sind.

Dabei ist unter dem Begriff "Sensor", wie er in der Beschreibung und den Ansprüchen verwendet wird, insbesondere eine Einheit zu verstehen, die dazu eingerichtet ist, aus Umweltveränderungen elektrische Signale abzuleiten, die die Umweltveränderungen im Rahmen einer Messgenauigkeit charakterisieren.

Vorzugsweise ist die Diagnoseschaltung zum Anschluss an die zweite Spannungsversorgung ausgebildet.

Dabei ist unter dem Begriff "Spannungsversorgung", wie er in der Beschreibung und den Ansprüchen verwendet wird, insbesondere eine Schaltung zu verstehen, die ausgangsseitig eine (im Wesentlichen) konstante Versorgungsspannung bzw. eine Versorgungsspannung mit im Wesentlichen konstanten Effektivwert bereitstellt.

Vorzugsweise ist die Diagnoseschaltung eingerichtet, eine Unterspannung oder Überspannung der zweiten Spannungsversorgung durch einen Bit-Wert zu signalisieren.

Dabei ist unter dem Begriff "Unter-/Überspannung", wie er in der Beschreibung und den Ansprüchen verwendet wird, insbesondere eine Spannung zu verstehen, die, bzw. deren Effektivwert, einen festgelegten Schwellenwert, welcher unterhalb bzw. oberhalb eines Nominalwertes liegt, unter- oder überschreitet.

Der erfindungsgemäße Mikrocontroller (bzw. eine den Mikrocontroller umfassende Schaltung, die einige oder alle der vorstehenden Elemente umfassen kann) kann ferner in einem Verfahren zur Überwachung einer Ausgangsspannung einer Spannungsversorgung verwendet werden. Bspw. kann (durch die Diagnoseschaltung) überwacht werden, ob die Ausgangsspannung in einem Sollspannungsbereich liegt und ein das Ergebnis symbolisierender Bit-Wert in eine Ausleseposition eines Schieberegisters, welche von dem Mikrocontroller über eine serielle Schnittstelle des Schieberegisters als erstes ausgelesen werden kann, geschrieben werden.

Dabei ist unter dem Begriff "Mikrocontroller", wie er in der Beschreibung und den Ansprüchen verwendet wird, insbesondere eine integrierte Schaltung zu verstehen, welche einen Prozessor umfasst und deren Gehäuse eine Vielzahl an Eingängen zugeordneten Anschluss-Pins zum Verbinden des Mikrocontrollers mit weiteren Schaltungsteilen aufweist.

Eine Spannung, die den in der ersten Ausleseposition des Schieberegisters gespeicherten Bit-Wert repräsentiert, kann fortwährend an eine mit der seriellen Schnittstelle verbundene Signalleitung, welche den Mikrocontroller mit dem Schieberegister verbindet, angelegt werden, wodurch dem Mikrocontroller der Statuswert auch ohne Zeittakt-Signal zur Verfügung steht.

Bspw. kann die Signalleitung (gegebenenfalls über eine Potenzialtrennung wie bspw. einen Optokoppler) mit einem Anschluss-Pin des Mikrocontroller-Gehäuses verbunden sein, wodurch ein während Auslesepausen auf die Signalleitung gegebener, dem Diagnosebit-Wert entsprechender Pegel über den seriellen Eingang des Mikrocontrollers fortwährend (in aktualisierter Form) zur Verfügung steht und von dem Mikrocontroller zu beliebigen Zeitpunkten zur Überprüfung der Versorgungsspannung eingelesen und ausgewertet werden kann.

Das Verfahren kann ferner ein Steuern einer Anlage auf Basis von aus dem Schieberegister ausgelesenen Messdaten umfassen, wobei die Messdaten durch Sensoren erzeugt werden, an denen die Ausgangsspannung oder eine von der Ausgangsspannung abgeleitete (erzeugte) Spannung anliegt.

Dabei ist unter dem Begriff "Anlage", wie er in der Beschreibung und den Ansprüchen verwendet wird, insbesondere ein Automatisierungssystem zu verstehen, welches Sensoren und Aktoren umfasst, die mit einer Feldversorgung (bspw. 24V) versorgt werden. Die Möglichkeit der Überprüfung der Versorgungsspannung erlaubt somit das Erkennen von Situationen, in denen die Messdaten unter widrigen Umständen angefertigt wurde und daher (möglicherweise mit) höherer Wahrscheinlichkeit inkorrekt sind.

### KURZBESCHREIBUNG DER ZEICHNUNGEN

Die Erfindung wird nachfolgend in der detaillierten Beschreibung anhand von Ausführungsbeispielen erläutert, wobei auf Zeichnungen Bezug genommen wird, in denen:
Fig. 1 ein Blockdiagramm einer beispielhaften Schaltung zur Überwachung einer Ausgangsspannung einer Spannungsversorgung;
Fig. 2a eine schematische Darstellung von Spannungsverläufen an ausgewählten Ein-/Ausgängen in der beispielhaften Schaltung der Fig. 1, gemäß einem ersten Beispiel;
Fig. 2b eine schematische Darstellung von Spannungsverläufen an ausgewählten Ein-/Ausgängen in der beispielhaften Schaltung der Fig. 1, gemäß einem zweiten Beispiel;
Fig. 2c eine schematische Darstellung von Signalen an ausgewählten Ein-/Ausgängen in der beispielhaften Schaltung der Fig. 1, gemäß einem weiteren Beispiel;
Fig. 3 ein Blockdiagramm mit zusätzlichen Elementen der beispielhaften Schaltung der Fig. 1;
Fig. 4 ein Blockdiagramm mit zusätzlichen Elementen der beispielhaften Schaltung der Fig. 3; und
Fig. 5 ein Flussdiagramm eines Prozesses zur Überwachung einer Ausgangsspannung einer Spannungsversorgung zeigt.

Dabei sind in den Zeichnungen gleiche Elemente durch gleiche Bezugszeichen gekennzeichnet.

### DETAILLIERTE BESCHREIBUNG

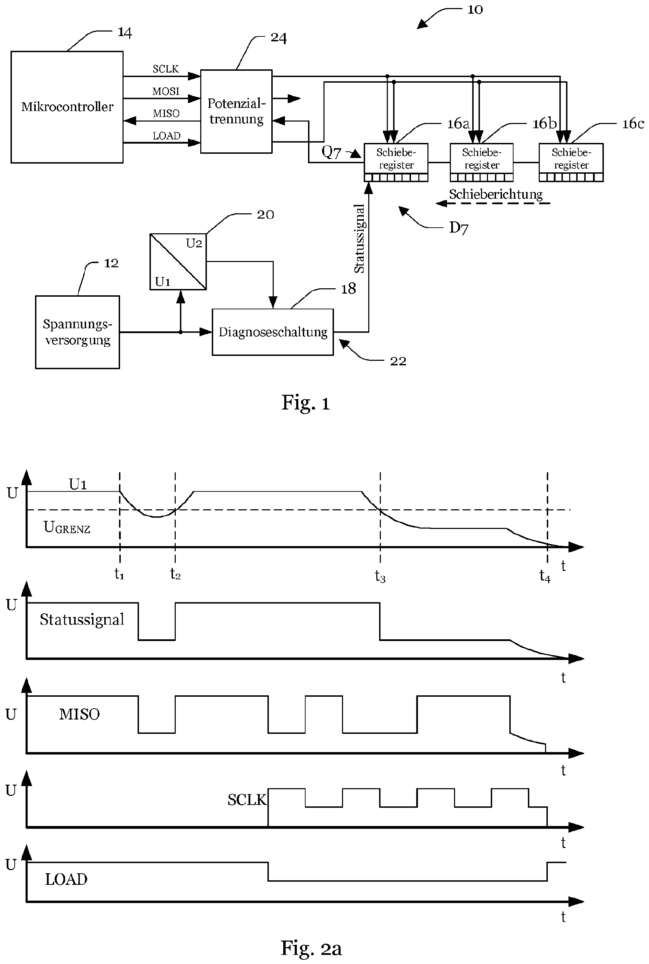

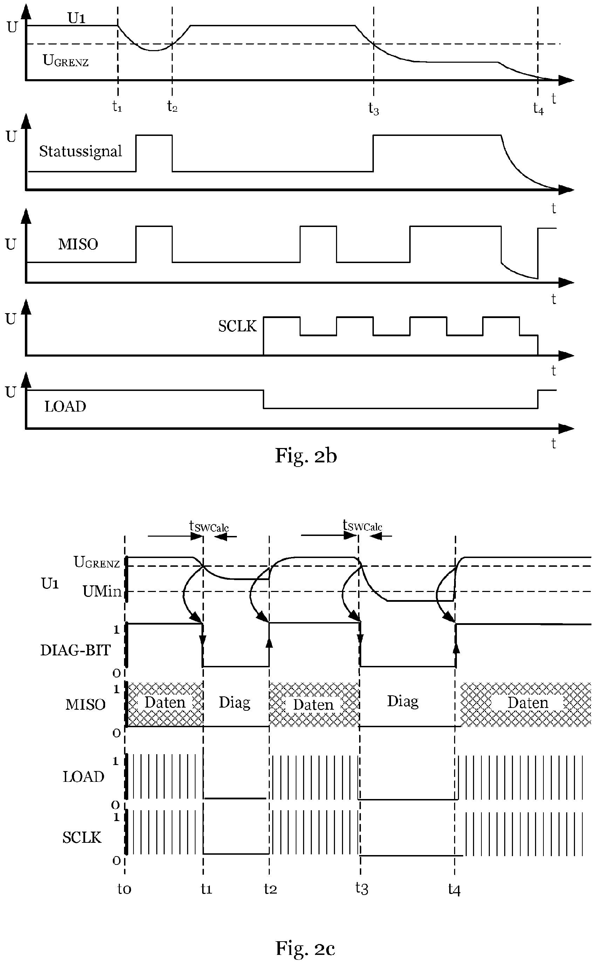

Fig. 1 zeigt ein Blockdiagramm einer beispielhaften Schaltung 10 zur Überwachung einer Ausgangsspannung einer Spannungsversorgung 12. Die Schaltung 10 umfasst einen Mikrocontroller 14 zur Steuerung einer Anlage (in Fig. 1 nicht gezeigt), mehrere Schieberegister 16a-16c und eine Diagnoseschaltung 18. Die Diagnoseschaltung 18 dient der Überwachung der Ausgangsspannung U1 der Spannungsversorgung 12 (bspw. eine 24V Feldversorgung) auf Unterspannung. Fällt die Ausgangsspannung U1 der Spannungsversorgung 12, wie in Fig. 2a und 2b gezeigt, unter einen Schwellenwert U_{GRENZ}, signalisiert die Diagnoseschaltung 18 dies am Diagnoseausgang 22 durch eine Änderung eines Statussignals (bspw. durch Änderung eines Statussignal-Pegels).

Der Diagnoseausgang 22 der Diagnoseschaltung 18 ist mit einem Dateneingang D7 eines Schieberegisters 16a zur Eingabe eines Diagnosebits verbunden. Der Mikrocontroller 14 weist einen Eingang zum Empfang von seriellen Ausgangsdaten der Schieberegister 16a-16c auf, wobei der Eingang über eine (optionale) Potenzialtrennung 24 (bspw. einen Optokoppler oder einen Digitalisolator) mit dem seriellen Ausgang Q7 des Schieberegisters 16a verbunden ist. Dadurch kann das Statussignal über das Schieberegister 16a und den seriellen Eingang des Mikrocontrollers 14 als Diagnosebit eingelesen werden.

Bspw. kann (wie in Fig. 2a und 2b gezeigt) eine Unterspannung (U1<U_{GRENZ}) durch Ausgabe eines definierten Logik-Pegels, z. B. durch Ausgabe eines Low-Pegels oder eines High-Pegels am Diagnoseausgang 22 signalisiert werden. Zudem ist die Diagnoseschaltung 18 nicht auf das Erkennen einer Unterspannung beschränkt. Bspw. kann die Diagnoseschaltung 18 ausgebildet sein, anstatt des Überwachens oder zusätzlich zum Überwachen der Ausgangsspannung U1 hinsichtlich Unterspannung, die Ausgangsspannung U1 auf Überspannung zu überwachen. Des Weiteren kann, wenn die Diagnoseschaltung 18 zum Überwachen der Ausgangsspannung U1 auf Unterspannung und Überspannung ausgebildet ist, ein Statussignal ausgegeben werden, dessen Pegel signalisiert, ob eine Unterspannung oder eine Überspannung vorliegt.

Ferner können anstatt eines einzelnen Statussignals zwei Statussignale ausgegeben werden, wobei bspw. der Pegel eines Statussignals dem Signalisieren einer Unterspannung und der Pegel des verbleibenden Statussignals dem Signalisieren einer Überspannung zugeordnet ist. Alternativ kann der Pegel eines Statussignals signalisieren, ob eine Unterspannung oder eine Überspannung (oder weder eine Unterspannung noch eine Überspannung) vorliegt und der Pegel des verbleibenden Statussignals im Falle einer Unter- oder Überspannung signalisieren, ob eine Unterspannung vorliegt oder ob eine Überspannung vorliegt. Die Statussignale können bspw. seriell über den Diagnoseausgang 22 oder parallel über zwei Diagnoseausgänge (nicht gezeigt) ausgegeben werden.

Durch Ausgeben eines Low-Pegels zum Signalisieren von Spannungsversorgungsproblemen (d. h. Unter- oder Überspannung) kann in Ausführungsformen, in denen die Versorgungsspannung U2 (Logikspannung) der Diagnoseschaltung 18 aus der Ausgangsspannung U1 der überwachten Spannungsversorgung 12 (durch einen Spannungswandler 20) erzeugt wird, vermieden werden, dass bei einem vollständigen Zusammenbruch der Ausgangsspannung U1, wie bspw. in Fig. 2a zum Zeitpunkt t₄ einsetzend, ein spannungsabfallbedingt verfälschtes Statussignal am Diagnoseausgang 22 der Diagnoseschaltung 18 ausgegeben wird.

Jedoch kann es auch vorteilhaft sein, Spannungsversorgungsprobleme (d. h. Unter- oder Überspannung) durch Ausgeben eines High-Pegels zu signalisieren. Bspw. kann die (optionale) Potenzialtrennung 24 eingerichtet sein, bei einem vollständigen Ausfall der Spanungsversorgung 12, wie bspw. in Fig. 2b zum Zeitpunkt t₄ gezeigt, einen High-Pegel zu erzeugen. Bei Verwendung eines High-Pegels zum Signalisieren von Spannungsversorgungsproblemen kann dann eine spannungsabfallbedingt verfälschte Übertragung des Statussignal-Pegels über die Potenzialtrennung 24 vermieden werden.

Fig. 2a zeigt dazu eine schematische Darstellung von Spannungsverläufen an ausgewählten Ein-/Ausgängen der Schaltung der Fig. 1, wobei eine Unterspannung von der Diagnoseschaltung 18 durch Ausgeben eines Low-Pegels am Diagnoseausgang 22 signalisiert wird. In der in Fig. 2a gezeigten Darstellung beginnt zum Zeitpunkt t₁ die Ausgangsspannung U1 abzusinken. Bspw. kann eine Verbindung zur Spannungsversorgung 12 unterbrochen worden sein. Solange die Ausgangsspannung U1 noch oberhalb der Grenzspannung U_{GRENZ} liegt, wird am Diagnoseausgang 22 der Diagnoseschaltung 18 ein High-Pegel erzeugt. Nachdem die Ausgangsspannung U1 unter die Grenzspannung U_{GRENZ} gesunken ist, wird am Diagnoseausgang 22 der Diagnoseschaltung 18 jedoch ein Low-Pegel erzeugt, der ein Spannungsversorgungsproblem signalisiert.

Wie in Fig. 2a gezeigt, wird an der ersten Bitposition des mit der Diagnoseschaltung 18 verbundenen Schieberegisters 16a ein dem jeweiligen Pegel des Statussignals entsprechender Bit-Wert (Diagnosebit) gespeichert. Ein dem an der ersten Bitposition gespeicherten Bit-Wert entsprechender Pegel wird ferner an dem mit dem Eingang des Mikrocontrollers 14 verbundenen seriellen Ausgang Q7 des Schieberegisters 16a erzeugt. Dadurch steht der Diagnosebit-Wert dem Mikrocontroller 14 zur Verfügung (bzw. erlaubt eine Überwachung durch den Mikrocontroller 14), ohne dass das (komplette) Schieberegister 16a durch den Mikrocontroller 14 ausgelesen werden muss. Da das Statussignal bei entsprechendem Pegel des LOAD-Signals fortlaufend eingelesen wird, ändert sich der Bit-Wert zum Zeitpunkt t₂, zu dem die Ausgangsspannung U1 über die Grenzspannung U_{GRENZ} steigt, erneut. Dadurch kann dem Mikrocontroller 14 auch das Überwinden eines (vorübergehenden) Spannungsversorgungsproblems signalisiert werden, ohne dass das (komplette) Schieberegister 16a durch den Mikrocontroller 14 ausgelesen werden muss.

Das Auslesen des mit dem Eingang des Mikrocontrollers 14 verbundenen Schieberegisters 16a kann dann (bei invertiertem LOAD-Pegel) durch das Anlegen eines Taktsignals SCLK an Takteingänge der Schieberegister 16a-16c bewirkt werden. Durch das Anlegen des Taktsignals SCLK an die Takteingänge der Schieberegister 16a-16c werden die in den Schieberegistern 16a-16c gespeicherten Daten im Takt des Taktsignals SCLK entlang der Schieberichtung zu dem mit dem Eingang des Mikrocontrollers 14 verbundenen seriellen Ausgang Q7 verschoben, wodurch die in den Schieberegistern 16a-16c gespeicherten Bit-Werte nacheinander über den seriellen Ausgang Q7 ausgegeben werden.

Das Sinken der Ausgangsspannung U1 unter die Grenzspannung U_{GRENZ} zum Zeitpunkt t₃ kann (in der gezeigten Ausführungsform) zwar nicht durch den Mikrocontroller 14 erfasst werden; da die in den Schieberegistern 16a-16c gespeicherten Daten jedoch zu einem Zeitpunkt erfasst wurden, zu dem sich die Ausgangsspannung U1 über der Grenzspannung U_{GRENZ} befand, stellt dies die Integrität der erfassten Daten nicht in Frage. Jedoch kann sich, wenn die Schieberegister 16a-16c durch die Spanungsversorgung 12 versorgt werden, das Abfallen der Ausgangsspannung U1 unter die Grenzspannung U_{GRENZ} zum Zeitpunkt t₃ auf die Funktion der Schieberegister 16a-16c auswirken.

Um diesem Rechnung zu tragen, kann die (optionale) Potenzialtrennung 24 eingerichtet sein, ein zum Zeitpunkt t₄ einsetzendes vollständiges Einbrechen der Ausgangsspannung U1 durch Ausgeben eines statischen Pegels zu signalisieren. Dieser kann vom Mikrocontroller 14 erfasst werden und der Mikrocontroller 14 kann eingerichtet sein, in Reaktion auf das Erfassen des statischen Pegels einen (invertierten) LOAD-Pegel auszugeben, der ein Einlesen des Statussignals bewirkt, wodurch bei Rückkehr der Ausgangsspannung U1 ein Überwinden des Spannungsversorgungsproblems erfasst werden kann.

Fig. 2b zeigt eine schematische Darstellung von Spannungsverläufen an ausgewählten Ein-/Ausgängen der Schaltung der Fig. 1, wobei eine Unterspannung von der Diagnoseschaltung 18 durch Ausgeben eines High-Pegels am Diagnoseausgang 22 signalisiert wird. Dabei erzeugt die Potenzialtrennung 24 zum Zeitpunkt t₄ einen High-Pegel am MISO-Eingang des Mikrocontrollers 14, der bei gestopptem SCLK-Signal dem Mikrocontroller 14 ein Spannungsversorgungsproblem signalisiert.

Fig. 2c zeigt eine schematische Darstellung von Signalen an ausgewählten Ein-/Ausgängen in der beispielhaften Schaltung der Fig. 1, gemäß einem weiteren Beispiel, wobei eine fehlerhafte Ausgangsspannung U1 von der Diagnoseschaltung 18 durch Ausgeben eines High-Pegels am Diagnoseausgang 22 signalisiert wird. Dabei läuft zum Zeitpunkt t0 ein Normbetrieb ab, in dem keine Spannungsversorgungsprobleme vorliegen und in den Schieberegistern 16a-16c gespeicherte Daten über den MISO-Eingang des Mikrocontrollers 14 eingelesen werden. Die LOAD-Leitung wird regelmäßig bedient und das SCLK-Signal taktet die Daten in den Mikrocontroller 14.

Zum Zeitpunkt t1 unterschreitet die Ausgangsspannung U1 den Grenzwert U_{Grenz}. Dieser liegt z. B. bei 18V, wenn die Ausgangsspannung U1 im Normbetrieb 24V beträgt. Aus der Ausgangsspannung U1 wird über einen Schaltregler/Spannungsumsetzer eine Logikversorgung generiert (z. B. eine 3,3V oder eine 5V Logikversorgung). Die Logikversorgung kann aus der unterhalb des Grenzwertes UGrenz liegenden Ausgangsspannung U1 (fehlerfrei) generiert werden, solange diese oberhalb der Spannung UMin liegt.

Der Mikrocontroller 14 erkennt mit einer gewissen Verarbeitungszeit, tSWCalc, dass das Diagnose-Bit (DIAG-Bit) im Datenstrom, welches den Status der Ausgangsspannung U1 signalisiert, eine fehlerhafte Ausgangsspannung U1 signalisiert und stellt die Datenkommunikation zu den Schieberegistern 16a-16c ein, indem der Mikrocontroller 14 die SCLK-Leitung nicht länger taktet. Die LOAD-Leitung wird dann auf einem statischen Low-Pegel (der in einer anderen Ausführungsform auch ein High-Pegel sein kann) gehalten, wodurch das DIAG-Signal statisch auf die MISO-Leitung geschaltet wird.

Der Mikrocontroller 14 fragt nun fortlaufend den MISO-Eingang ab und prüft, ob das DIAG-Bit bzw. das Statussignal eine Wiederkehr der Ausgangsspannung U1 signalisiert. Wenn die Ausgangsspannung U1, wie zum Zeitpunkt t2 wieder den Schwellwert U_{Grenz} übersteigt, wechselt das DIAG-Bit seinen Wert auf Ausgangsspannung U1 "fehlerfrei". Da der Mikrocontroller 14 den Port-Pin des Dateneingangssignals (MISO) fortlaufend abfragt, erkennt die Software, dass die Ausgangsspannung U1 wieder im Normbereich ist. Daraufhin kann die Datenkommunikation wiederaufgenommen werden. D. h. das LOAD-Signal kann wieder zyklisch bedient und das SCLK-Signal die Eingangsdaten takten.

Wenn, wie zum Zeitpunkt t3, die Ausgangsspannung U1 vollständig zusammenbricht und UMin unterschreitet, erkennt der Mikrocontroller 14 dies am DIAG-Bit und stellt die Datenkommunikation ein. Das anschließende regelmäßige Abfragen des Port-Pins erfolgt wie zum Zeitpunkt t1+SWCALC, nur mit dem Unterscheid, dass die Ausgangsspannung U1 vollständig zusammengebrochen ist. Dies kann bei entsprechender Schaltungsauslegung durch den Mikrocontroller 14 als vollständig zusammengebrochene Ausgangsspannung U1 erkannt werden.

Bspw. kann die Potenzialtrennung 24 einen Digitalisolator aufweisen, der bei einem vollständigen Zusammenbruch der Ausgangsspannung U1 Mikrocontroller-seitig dauerhaft einen festen Pegel ausgibt. Der feste Pegel kann genau dem Pegel entsprechen, der für eine fehlerhafte Ausgangsspannung U1 steht. Sobald dann die Ausgangsspannung U1 zum Zeitpunkt t4 wiederhergestellt ist, signalisiert das DIAG-Bit wieder den korrekten Zustand der Ausgangsspannung U1.

Während somit vor dem Anliegen des Taktsignals SCLK und nach dem Anliegen des Taktsignals SCLK über den seriellen Ausgang Q7 der Diagnosebit-Wert ausgegeben werden kann, können während des Anliegens des Taktsignals SCLK sukzessive die in den Schiebregistern 16a-16c gespeicherten Ausgangsdaten über den seriellen Ausgang Q7 ausgegeben werden. Allerdings kann in einer weiteren Ausführungsform das Schieberegister 16a so ausgestaltet sein, dass ein Auslesen des Diagnosebit-Werts nur durch Anlegen des Taktsignals SCLK bewirkt werden kann, der Diagnosebit-Wert somit vor und nach dem Anliegen des Taktsignals SCLK über den seriellen Ausgang Q7 nicht ausgegeben wird.

Ferner kann ein dem jeweiligen Pegel des Statussignals entsprechender Bit-Wert auch an einer anderen als an der ersten Bitposition des mit der Diagnoseschaltung 18 verbundenen Schieberegisters 16a gespeichert werden. Zudem können die Schieberegister 16a-16c zwei Schieberichtungen aufweisen und sowohl das Einlesen als auch das Ausgeben von Daten über die Schieberegister 16a-16c erfolgen.

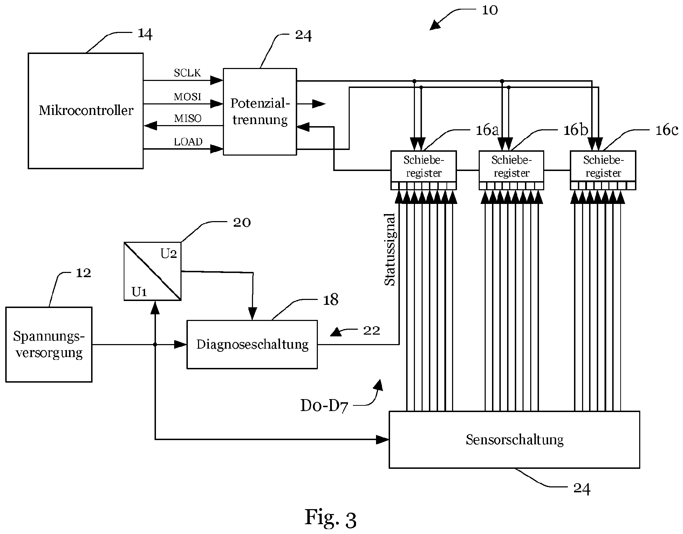

Fig. 3 zeigt ein Blockdiagramm mit zusätzlichen Elementen der beispielhaften Schaltung 10 der Fig. 1. Insbesondere zeigt Fig. 3 eine Sensorschaltung 26, welche einen oder mehrere Sensoren und eine Vielzahl an parallelen Ausgängen zur Bereitstellung von Messdaten umfasst. Die Ausgänge der Sensorschaltung 26 sind mit parallelen Eingängen D0-D7 der Schieberegister 16a-16c verbunden. Somit können die Sensordaten parallel in die Schieberegister 16a-16c geladen werden. Die Sensorschaltung 26 wird ferner durch die Spannungsversorgung 12 versorgt. Tritt eine Unterspannung oder Überspannung auf, kann die Funktionalität der Sensorschaltung 26 beeinträchtigt werden und es können auf Grund dessen keine Sensordaten oder inkorrekte Sensordaten bereitgestellt werden.

Diese Problematik kann durch das Bereitstellen des Diagnosebit-Werts (bzw. mehrerer Diagnosebit-Werte) insofern entschärft werden, als der Mikrocontroller 14 durch Auswerten des Diagnosebit-Werts (bzw. der Diagnosebit-Werte) und Verwerfen der (möglicherweise) betroffenen Sensordaten bei Auftreten einer Unterspannung oder Überspannung die Gefahr einer Verwendung inkorrekter Daten verringern kann. Bspw. kann der Mikrocontroller 14 bei Auftreten einer Unterspannung oder Überspannung die Sensordaten plausibilisieren, Sensordaten aus einer redundanten Sensorschaltung (nicht gezeigt) verwenden, oder einen auf Basis der Sensordaten gesteuerten Prozess anhalten.

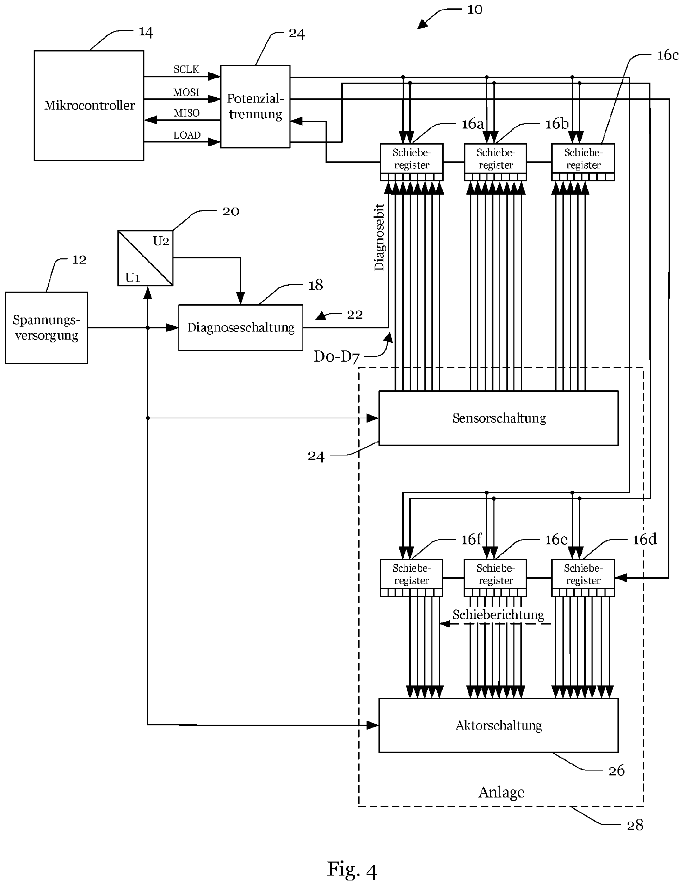

Fig. 4 zeigt ein Blockdiagramm mit zusätzlichen Elementen der beispielhaften Schaltung 10 der Fig. 3. Insbesondere zeigt die Fig. 4 neben der in Fig. 3 gezeigten Sensorschaltung 26 eine ebenfalls durch die Spannungsversorgung 12 versorgte Aktorschaltung 28. Sensorschaltung 26 und Aktorschaltung 28 sind Teil einer durch den Mikrocontroller 14 gesteuerten Anlage 30. Bspw. steuert der Mikrocontroller 14 einen oder mehrere Aktoren der Aktorschaltung 28 auf Basis von Sensordaten der Sensorschaltung 26. Dabei können einer oder mehrere Aktoren der Aktorschaltung 28 in einen Prozess involviert sein, der durch die Aktoren beeinflusst/gesteuert wird. Bei einer erkannten Unterspannung kann der Mikrocontroller 14 bspw. die Aktoren stoppen oder in einen vorbestimmten Zustand überführen, um einen möglicherwiese unkontrollierten (ungewollten) Zustand der Anlage 30 zu vermeiden.

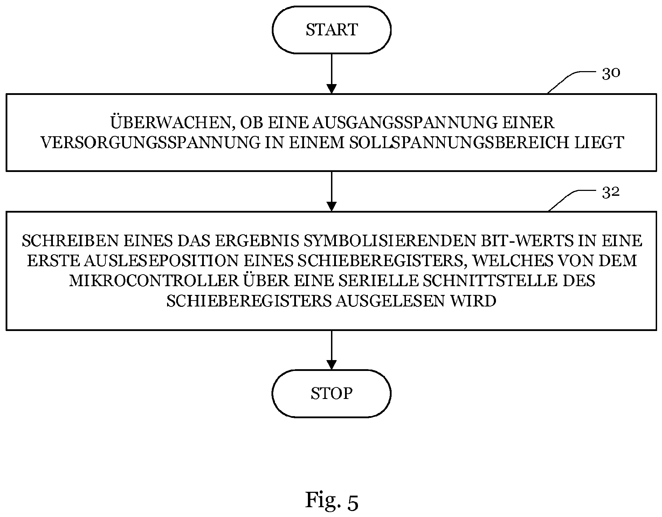

Fig. 5 zeigt ein Flussdiagramm eines Prozesses zur Überwachung einer Ausgangsspannung der Spannungsversorgung 12. Bei 32 wird überwacht, ob die Ausgangsspannung der Spannungsversorgung 12 in einem Sollspannungsbereich liegt. Bei 34 wird ein das Ergebnis der Überwachung symbolisierender Bit-Wert in eine erste Ausleseposition des Schieberegisters 16a, welches von dem Mikrocontroller 14 über die serielle Schnittstelle Q7 des Schieberegisters 16a ausgelesen wird, geschrieben. Das Schreiben des Bit-Werts in die erste Ausleseposition des Schieberegisters 16a kann ohne Takten des Schieberegisters 16a erfolgen.

Zum Übertragen des Überwachungsergebnisses an den Mikrocontroller 14 kann dabei, wie in Fig. 1, 3 und 4 gezeigt, eine I/O-Übertragungsstrecke verwendet werden, die über eine serielle synchrone Schnittstelle betrieben wird. Die I/O-Übertragungsstrecke kann dabei als Parallel-Seriell-Wandler ausgebildete Schieberegister 16a-16c ansteuern, die feldseitig betrieben und über eine feldseitige Logikversorgung U2 versorgt werden, wobei die feldseitige Logikversorgung U2 aus (einer 24V Feldspannung) U1 generiert werden kann. Ferner kann die Logikversorgung U2 auch aus einer Spannung eines Logikpotentials generiert werden.

U1 und auch U2 können über die Diagnoseschaltung 18 auf Unterspannung und auf Überspannung überwacht werden. Die Diagnoseschaltung 18 erzeugt basierend auf der Überwachung ein Statussignal, welches bei fehlerfreier Versorgungsspannung U1/U2 z. B. einem Low-Pegel und bei fehlerhafter Versorgungsspannung U1/U2 z. B. einem High-Pegel entspricht, wobei das umgekehrte Verhalten ebenso möglich ist.

Über das als Parallel-Seriell-Wandler ausgebildete Schieberegister 16a kann das Statussignal von einem (oder mehreren) Mikrocontrollern 14 auf dem Logikpotential eingelesen und weiterverarbeitet werden. Dabei kann das Statussignal an die erste Bitposition des Parallel-Serial-Wandlers geschrieben werden, wodurch das Diagnose-Bit das erste Bit ist, welches von dem einem (oder den mehreren) Mikrocontroller 14 beim Takten der I/O-Übertragungsstrecke eingelesen wird.

Wenn der Parallel-Seriell-Wandler, wie in Fig. 2a-2c gezeigt, solcher Bauart ist, dass auch ohne das Takten der I/O-Übertragungsstrecke der Signalzustand des Anschluss-Pins für das erste Bit auf den seriellen Ausgang Q7 ausgegeben wird, dann ist auch ohne Takten der Übertragungsstrecke das Einlesen des Statussignals möglich. Dadurch kann durch bloßes Abfragen des Signalzustandes am entsprechenden Anschluss-Pin (MISO) des Mikrocontrollers 14 und ohne einen Betrieb (d. h. ohne das Takten) der seriellen synchronen Schnittstelle der Zustand der Spannungsversorgung 12 (Feldversorgung) abgefragt und auf Wiederkehr geprüft werden.

Ferner kann ein Optokoppler/Digitalisolator und ein Anschluss/Port-Pin am Mikrocontroller 14 eingespart werden, weil ein Pin am Port-Expander und nicht am Mikrocontroller 14 verwendet wird, der ggf. ohnehin (wie in Fig. 3 und 4 gezeigt) unbelegt wäre. Eine Portexpander-Erweiterung ist ferner (durch Hinzufügen eines weiteren Schieberegisters 16) jederzeit möglich, während die Anzahl der Mikrocontroller-Pins typischerweise beschränkt ist.

Ist die Schaltung 10 Teil eines sicherheitsgerichteten Systems kann aufgrund normativer Anforderungen eine zweikanalige Struktur der Hardware notwendig sein. Insbesondere kann das System zwei Mikrocontroller 14, zwei I/O-Übertragungsstrecken und zwei Diagnoseschaltungen 18 umfassen.

### BEZUGSZEICHENLISTE

- 10: Schaltung
- 12: Spannungsversorgung
- 14: Mikrocontroller
- 16: Schieberegister
- 18: Diagnoseschaltung
- 20: Spannungswandler
- 22: Diagnoseausgang
- 24: Potenzialtrennung
- 26: Sensorschaltung
- 28: Aktorschaltung
- 30: Anlage
- 32: Prozessschritt
- 34: Prozessschritt

## Patentansprüche

1. Schaltung (10), umfassend:
einen Mikrocontroller (14) zur Steuerung einer Anlage;
ein Schieberegister (16); und
eine Diagnoseschaltung (18);
wobei der Mikrocontroller (14) zum Anschluss an eine erste Spannungsversorgung ausgebildet ist und einen Eingang (MISO) zum Empfang von seriellen Ausgangsdaten des Schieberegister (16) aufweist, wobei der Eingang (MISO) mit dem seriellen Ausgang (Q7) des Schieberegisters (16) verbunden ist, und das Schieberegister zumindest einen Dateneingang (D7) aufweist;
wobei die Schaltung (10) **dadurch gekennzeichnet ist, dass**
die Diagnoseschaltung (18) zur Diagnose einer zweiten Spannungsversorgung (12) ausgebildet ist und ein Diagnoseausgang (22) der Diagnoseschaltung (18) mit dem Dateneingang (D7) des Schieberegisters (16) zur Eingabe eines Diagnosebits verbunden ist.

2. Schaltung (10) nach Anspruch 1, wobei der Dateneingang (D7) Bestandteil einer parallelen Schnittstelle (D0-D7) des Schieberegisters (16) ist.

3. Schaltung (10) nach Anspruch 1 oder 2, wobei der Dateneingang (D7) des Schieberegisters (16) zur Speicherung des Diagnosebits an einem Speicherplatz eingerichtet ist, dessen Inhalt bei der seriellen Ausgabe zuerst ausgegeben wird.

4. Schaltung (10) nach Anspruch 3, wobei das Schieberegister (16) zum Anlegen eines dem Diagnosebit entsprechenden Wertes an den Eingang (MISO) des Mikrocontrollers (14) ohne Anliegen eines Taktsignals (SCLK) an einem Takteingang des Schieberegisters (16) und/oder einer an dem Schieberegister (16) anliegenden Logikspannung (U2) eingerichtet ist.

5. Schaltung (10) nach einem der Ansprüche 1 bis 4, ferner umfassend :
einen oder mehrere Sensoren, die zum Anschluss an die zweite Spannungsversorgung (12) ausgebildet sind;
wobei ein oder mehrere Dateneingänge (D0-D6) des Schieberegisters (16) mit dem einen oder den mehreren Sensoren zur Eingabe von Sensordaten verbunden sind.

6. Schaltung (10) nach einem der Ansprüche 1 bis 5, wobei die Diagnoseschaltung (18) zum Anschluss an die zweite Spannungsversorgung (12) ausgebildet ist.

7. Schaltung (10) nach Anspruch 6, wobei die Diagnoseschaltung (18) eingerichtet ist, eine Unterspannung oder Überspannung der zweiten Spannungsversorgung (12) durch einen Bit-Wert zu signalisieren.

8. Verfahren zur Überwachung einer Ausgangsspannung (U1) einer Spannungsversorgung (12), umfassend:
Überwachen (32), ob die Ausgangsspannung (U1) in einem Sollspannungsbereich liegt; und
Signalisieren des Ergebnisses des Überwachens an einen Mikrocontroller (14);
**gekennzeichnet durch**
Schreiben (34) eines das Ergebnis symbolisierenden Bit-Werts in eine Ausleseposition eines Schieberegisters (16), welche von dem Mikrocontroller (14) über eine serielle Schnittstelle (Q7) des Schieberegisters (16) als erstes ausgelesen wird.

9. Verfahren nach Anspruch 8, ferner umfassend:
fortwährendes Anlegen einer Spannung, die den in der ersten Ausleseposition des Schieberegisters (16) gespeicherten Bit-Wert repräsentiert, an eine mit der seriellen Schnittstelle (Q7) verbundene Signalleitung, welche den Mikrocontroller (14) mit dem Schieberegister (16) verbindet.

10. Verfahren nach einem der Ansprüche 8 oder 9, ferner umfassend :
Steuern einer Anlage (30) auf Basis von aus dem Schieberegister (16) ausgelesenen Messdaten; wobei die Messdaten durch Sensoren erzeugt werden, an denen die Ausgangsspannung (U1) oder eine von der Ausgangsspannung (U1) abgeleitete Spannung (U2) anliegt.

## Claims

1. Circuit (10), comprising:
a micro controller (14) for controlling a system;
a shift register (16); and
a diagnostic circuit (18);
wherein the micro controller (14) is designed for connection to a first voltage supply and has an input (MISO) for receiving serial output data from the shift register (16), wherein the input (MISO) is connected to the serial output (Q7) of the shift register (16) and the shift register has at least one data input (D7);
wherein the circuit (10) is **characterized in that**
the diagnostic circuit (18) is designed to diagnose a second voltage supply (12) and a diagnostic output (22) of the diagnostic circuit (18) is connected to the data input (D7) of the shift register (16) for inputting a diagnostic bit.

2. Circuit (10) according to claim 1, wherein the data input (D7) is a component of a parallel interface (D0-D7) of the shift register (16).

3. Circuit (10) according to claim 1 or 2, wherein the data input (D7) of the shift register (16) is configured to store the diagnostic bit at a storage space, the contents of which are first outputted at the serial output.

4. Circuit (10) according to claim 3, wherein the shift register (16) is configured to apply a value corresponding to the diagnostic bit to the input (MISO) of the micro controller (14) without applying a clock signal (SCLK) to a clock input of the shift register (16) and/or a logic voltage (U2) applied to the shift register (16).

5. Circuit (10) according to any of claims 1 to 4, further comprising:
one or more sensors, which are designed for connection to the second voltage supply (12);
wherein one or more data inputs (D0-D6) of the shift register (16) are connected to the one or more sensors for inputting sensor data.

6. Circuit (10) according to any of claims 1 to 5, wherein the diagnostic circuit (18) is designed for connection to the second voltage supply (12).

7. Circuit (10) according to claim 6, wherein the diagnostic circuit (18) is configured to signal an undervoltage or overvoltage of the second voltage supply (12) by means of a bit value.

8. Method for monitoring an output voltage (U1) of a voltage supply (12), comprising:
monitoring (32) whether the output voltage (U1) is within a target voltage range; and
signaling the result of the monitoring to a micro controller (14);
**characterized by**
writing (34) a bit value symbolizing the result in a readout position of a shift register (16) which is read out first by the micro controller (14) via a serial interface (Q7) of the shift register (16).

9. Method according to claim 8, further comprising:
continual application of a voltage, which represents the bit value stored in the first readout position of the shift register (16), to a signal line, connected to the serial interface (Q7), which connects the micro controller (14) to the shift register (16).

10. Method according to any one of claims 8 or 9, further comprising:
controlling a system (30) on the basis of measuring data read out from the shift register (16); wherein the measuring data are generated by sensors at which the output voltage (U1) or a voltage (U2) derived from the output voltage (U1) is applied.

## Revendications

1. Circuit (10) comprenant :
un microcontrôleur (14) pour la commande d'une installation ;
un registre à décalage (16) ; et
un circuit de diagnostic (18) ;
dans lequel le microcontrôleur (14) est réalisé pour le raccordement à une première alimentation en tension et présente une entrée (MISO) pour la réception de données de sortie série du registre à décalage (16), dans lequel l'entrée (MISO) est reliée à la sortie série (Q7) du registre à décalage (16), et le registre à décalage présente au moins une entrée de données (D7) ;
dans lequel le circuit (10) est **caractérisé en ce que**
le circuit de diagnostic (18) est réalisé pour le diagnostic d'une seconde alimentation en tension (12) et une sortie de diagnostic (22) du circuit de diagnostic (18) est reliée à l'entrée de données (D7) du registre à décalage (16) pour la saisie d'un bit de diagnostic.

2. Circuit (10) selon la revendication 1, dans lequel l'entrée de données (D7) fait partie d'une interface parallèle (D0-D7) du registre à décalage (16).

3. Circuit (10) selon la revendication 1 ou 2, dans lequel l'entrée de données (D7) du registre à décalage (16) est conçue pour le stockage du bit de diagnostic au niveau d'un espace de stockage, dont le contenu est tout d'abord délivré lors de la sortie série.

4. Circuit (10) selon la revendication 3, dans lequel le registre à décalage (16) est conçu pour l'application d'une valeur correspondante au bit de diagnostic à l'entrée (MISO) du microcontrôleur (14) sans application d'un signal d'horloge (SCLK) à une entrée d'horloge du registre à décalage (16) et/ou une tension logique (U2) appliquée au registre à décalage (16).

5. Circuit (10) selon l'une quelconque des revendications 1 à 4, comprenant de plus :
un ou plusieurs capteurs qui sont réalisés pour le raccordement à la seconde alimentation en tension (12) ;
dans lequel une ou plusieurs entrées de données (D0-D6) du registre à décalage (16) sont reliées à l'un ou aux plusieurs capteurs pour la saisie de données de capteur.

6. Circuit (10) selon l'une quelconque des revendications 1 à 5, dans lequel le circuit de diagnostic (18) est réalisé pour le raccordement à la seconde alimentation en tension (12).

7. Circuit (10) selon la revendication 6, dans lequel le circuit de diagnostic (18) est conçu afin de signaler une sous-tension ou surtension de la seconde alimentation en tension (12) par une valeur de bit.

8. Procédé de surveillance d'une tension de sortie (U1) d'une alimentation en tension (12), comprenant :
la surveillance (32) si la tension de sortie (U1) se trouve dans une plage de tension de consigne ; et
le signalement du résultat de la surveillance à un microcontrôleur (14) ;
**caractérisé par**
l'écriture (34) d'une valeur de bit symbolisant le résultat dans une position de lecture d'un registre à décalage (16) qui est lue en premier par le microcontrôleur (14) via une interface série (Q7) du registre à décalage (16).

9. Procédé selon la revendication 8, comprenant de plus :
l'application continue d'une tension qui représente la valeur de bit enregistrée dans la première position de lecture du registre à décalage (16), à un câble de signal reliée à l'interface série (Q7) qui relie le microcontrôleur (14) au registre à décalage (16).

10. Procédé selon l'une quelconque des revendications 8 ou 9, comprenant de plus :
la commande d'une installation (30) sur la base de données de mesure lues depuis le registre à décalage (16) ; dans lequel les données de mesure sont générées par des capteurs auxquels la tension de sortie (U1) ou une tension (U2) dérivée de la tension de sortie (U1) est appliquée.
